(19) **Europäisches Patentamt**

**European Patent Office**

**Office européen des brevets**

(11) **EP 1 001 535 B1**

(12) **EUROPEAN PATENT SPECIFICATION**

(45) Date of publication and mention
of the grant of the patent:
**26.01.2005 Bulletin 2005/04**

(51) Int Cl.⁷: **H03K 17/16**

(21) Application number: **98830679.1**

(22) Date of filing: **10.11.1998**

(54) **Circuit for controlling the slew rate of the output voltage of a driver in push-pull configuration**

Schaltung zum Steuern der Änderungsgeschwindigkeit der Ausgangsspannung eines Treibers in Gegentakt-Konfiguration

Circuit servant à commander le taux de variation de la tension de sortie d'un circuit d'attaque à configuration symétrique

(84) Designated Contracting States:
**DE FR GB IT**

(43) Date of publication of application:
**17.05.2000 Bulletin 2000/20**

(73) Proprietor: **STMicroelectronics S.r.l.**
**20041 Agrate Brianza (Milano) (IT)**

(72) Inventors:
• **Pioppo, Sergio Franco**
**95030 Mascalucia (Prov. Catania) (IT)**

• **Cala' Ignazio**
**90146 Palermo (IT)**

(74) Representative: **Modiano, Guido, Dr.-Ing. et al**
**Dr. Modiano & Associati SpA**
**Via Meravigli, 16**
**20123 Milano (IT)**

(56) References cited:
**EP-A- 0 457 595     EP-A- 0 492 506**
**US-A- 5 736 888     US-A- 5 828 245**

## Description

The present invention relates to a circuit for controlling the slew rate of the output voltage of a driver in push-pull configuration.

It is known that it is important to be able to control the slew rate of the output signal of a driver so that the output switching fronts of the signal are neither too fast nor too slow, in order to ensure perfect control of the output waveform as the load connected to the driver varies.

In particular, for example in the execution of drivers for RS232 serial interfaces, the load is of the ohmic-capacitive type.

When operating at data rates on the order of one hundred kbps it is important to be able to precisely control the slew rate of the output waveform of the signal of the driver in order to ensure a preset data transmission rate.

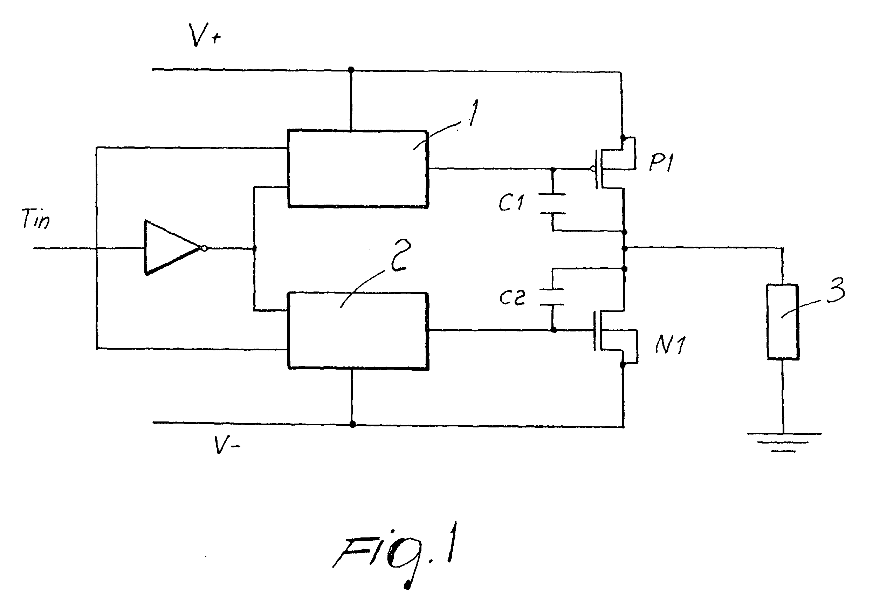

A known solution for controlling the slew rate of the output signal of a driver is shown in Figure 1, in which the input signal of the driver Tin is input to a first positive boost circuit 1, which is meant to boost the signal to the voltage V+ obtained from a charge pump circuit, and is also input to a second negative boost circuit 2, which is meant to bring the level of the signal Tin down to the level V-, which is obtained by inverting the voltage obtained from the charge pump circuit.

Two capacitors C1 and C2 are connected between the output Tout of the driver and gate terminals of a PMOS transistor P1 and of an NMOS transistor N1, which are respectively connected in output to the positive boost circuit 1 and to the negative boost circuit 2.

The load of the ohmic-capacitive type, designated by the reference numeral 3, is driven by the output signal Tout.

This solution, however, entails drawbacks.

First of all, in order to be able to use capacitors C1 and C2 whose capacitance is not excessively high, the connection of said capacitors between the output terminal and the gate terminals of the corresponding MOS final stages is utilized so as to be able to exploit the multiplying Miller effect obtained by the amplification provided by the transistor P1, N1, which is on at that time.

This entails a lack of precision because it is impossible to provide perfect control of the amplification of the MOS final stages P1, N1.

Owing to the connection of the MOS final stages P1 and N1, when the transistor P1, of the P-channel type, is on, the transistor N1 is instead off.

Accordingly, the capacitor C2 that intervenes during the slowing of the falling front of the output signal is subjected to a potential difference given by

$$V2 = (V+) - Vds(P1)-(V-)$$

where Vds(P1) is the voltage between the drain terminal and the source terminal of the transistor P1.

On the contrary, in the dual configuration characterized by the presence of the transistor P1 in the off state and of the transistor N1 in the on state, the capacitor C1 is subjected to a potential difference given by:

$$V1 = (V+)-[(V-)+Vds(N1)]$$

where Vds(N 1) is the voltage between the drain terminal and the source terminal of the transistor N1.

For example, in an application in an RS232 serial interface, the difference in voltage between V+ and V- is high and it is therefore necessary to use high-voltage capacitors, consequently increasing the area occupied by the capacitors in a chip.

Finally, the charging and discharging currents of the two capacitors C1 and C2 cannot be controlled, since they are linked to the output levels of the corresponding negative and positive boost circuits 1 and 2.

EP-A-0 492 506 discloses a fast capacitive-load driving circuit for integrated circuits, wherein no use is made of two distinct and independently generated slopes to control the output stage.

The aim of the present invention is therefore to provide a circuit for controlling the slew rate of the output voltage of a driver in push-pull configuration which allows to keep the slew rate within a preset interval even when the temperature varies.

Within this aim, an object of the present invention is to provide a circuit for controlling the slew rate of the output voltage of a driver in push-pull configuration which has a reduced area occupation with respect to known solutions and can therefore be easily integrated.

Another object of the present invention is to provide a circuit for controlling the slew rate of the output voltage of a driver in push-pull configuration which allows to act independently on the individual switching front of the output signal of the driver.

Another object of the present invention is to provide a circuit for controlling the slew rate of the output voltage of a driver in push-pull configuration in which the short-circuit currents can be controlled in a simple manner, eliminating additional circuits for controlling them.

Another object of the present invention is to provide a circuit for controlling the slew rate of the output voltage of a driver in push-pull configuration which is particularly adapted whenever it is necessary to drive in a controlled manner a pair of MOS final transistors connected in a push-pull configuration.

Another object of the present invention is to provide a circuit for controlling the slew rate of the output voltage of a driver in push-pull configuration which is highly reliable, relatively easy to manufacture and at competitive costs.

This aim, these objects and others which will become apparent hereinafter are achieved by a circuit for controlling the slew rate of the output voltage of a driver in push-pull configuration, as defined in claim 1.

Further characteristics and advantages of the invention will become apparent from the description of a preferred embodiment of the circuit according to the invention, illustrated only by way of non-limitative example in the accompanying drawings, wherein:

> Figure 1 is an exemplifying diagram of a conventional driver; and
> Figure 2 is a circuit diagram of a driver executed according to the present invention.

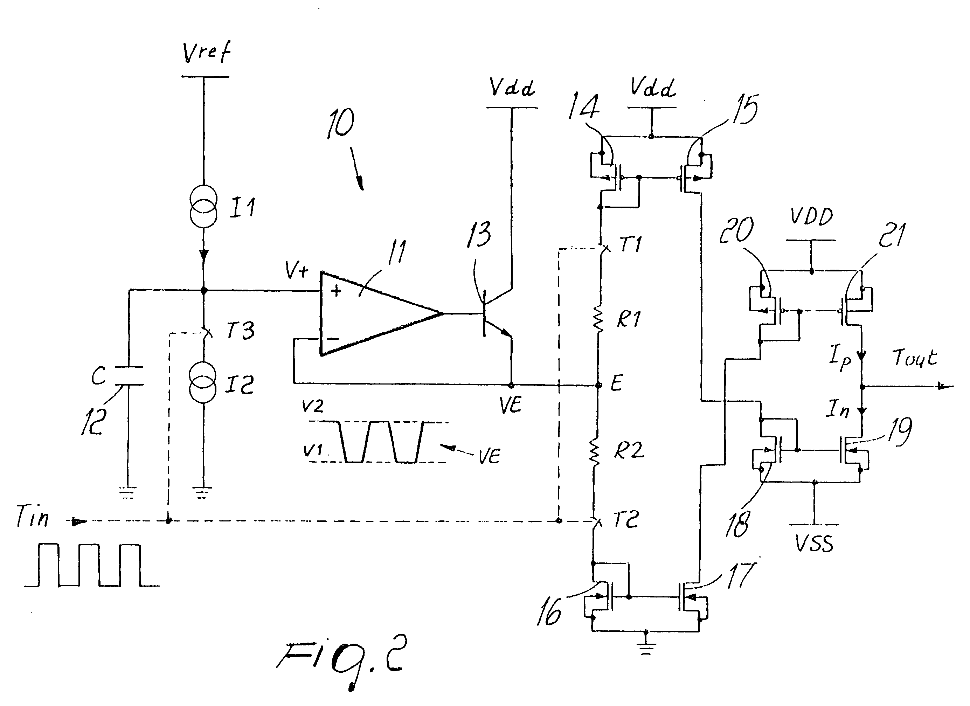

With reference to the above figures, and particularly to Figure 2 since Figure 1 has already been described, the circuit for controlling the slew rate of the output voltage of a driver, generally designated by the reference numeral 10, comprises an operational amplifier of the noninverting type, designated by the reference numeral 11, and at least one capacitive means 12 is connected to the noninverting terminal of said operational amplifier and is also connected to the ground.

Two current sources I1 and I2 are series-connected between a reference voltage Vref and the ground and are connected, with a common node, to the noninverting input terminal of the operational amplifier 11.

The input signal of the driver, Tin, drives a switch T3 which is arranged between the two current sources I1 and I2 and is conveniently provided for example by means of a MOS transistor; the signal Tin also drives another pair of switches T1 and T2 which are also provided, for example, by means of MOS transistors and are described in detail hereinafter.

The output of the operational amplifier 11 is connected to a bipolar transistor 13, in which the collector terminal is connected to the supply voltage Vdd and the emitter terminal is connected to the inverting terminal of the operational amplifier 11.

The two current sources I1 and I2 are constant-current sources driven, as mentioned, by the input signal Tin.

The emitter terminal of the transistor 13 is connected to two current mirrors which are formed respectively by P-channel MOS transistors 14 and 15 and by N-channel MOS transistors 16 and 17.

The first current mirror, formed by the transistors 14 and 15, is connected to a third current mirror which is formed by N-channel MOS transistors 18 and 19, while the second current mirror, formed by the MOS transistors 16 and 17, is connected to a fourth current mirror formed by P-channel MOS transistors 20 and 21.

The emitter terminal of the bipolar transistor 13 is connected at a common node E between the first current mirror and the second current mirror. A resistor R1 and the switch T1 are interposed between the node E and the first current mirror, and a resistor R2 and the switch T2 are interposed between the node E and the second current mirror.

The first current mirror is connected to the supply voltage Vdd, while the second current mirror is connected to the ground.

As mentioned, the input signal of the driver, Tin, drives the switches T1 and T2 as described hereinafter.

The third current mirror, formed by the transistors 18 and 19, is connected to the voltage Vss, which is the opposite of the voltage Vdd (obtained by means of a charge pump circuit), to which the fourth current mirror formed by the MOS transistors 20 and 21 is connected.

The P-channel MOS transistor 21 and the N-channel MOS transistor 19 constitute the final stages of the driver, and the output Tout, which then drives the ohmic-capacitive load, is taken between their drain terminals.

Accordingly with reference to Figure 2, the operation of the circuit for controlling the slew rate of the output signal according to the invention is as follows.

Whereas the known solution illustrated in Figure 1 performs voltage-based control, the solution according to the present invention converts controlled voltage fronts into current fronts used to drive the MOS final stages 21 and 19 of the driver.

In this manner it is possible to obtain in output a signal having a perfectly controllable slew rate.

It is accordingly possible to obtain positive and negative voltage fronts with a controlled slope by means of the charging and discharging of the capacitor C through the constant-current sources I1 and I2 driven by the input signal Tin.

The voltage Ve that is present at the emitter terminal of the transistor 13 and therefore at the node E can vary between two values V2 and V1 which are, respectively, the supply voltage Vdd and the ground.

Designating the value of the capacitor 12 as C for the sake of simplicity, the following relations apply for the charging and discharging of said capacitor:

for charging:

$$I1 = \frac{C \times (V2 - V1)}{\Delta T} \rightarrow \frac{\Delta Vc}{\Delta T} = \frac{I1}{C}$$

where

$$\Delta Vc$$

is the voltage variation across the capacitive element C (capacitor 12).

For discharging the capacitive element C, one has instead:

$$I1 - I2 = \frac{C \times (V2 - V1)}{\Delta T} \rightarrow \frac{\Delta Vs}{\Delta T} = \frac{I1 - I2}{C}$$

Accordingly, by acting on the value of the capacitive element C (capacitor 12) and on the currents I1 and I2 it is possible to adjust the slope of said fronts, which are unchanged at the node E by virtue of the presence of the operational amplifier 11 which is connected to voltage followers by means of the transistor 13.

The switch T3, when closed, causes the discharge of the capacitor 12, while it causes the charging of said capacitor when it is open.

The positive and negative voltage fronts are then converted into controlled current fronts by means of the resistors R1 and R2.

The current that flows across the resistor R1, designated by IR1 (t), is given by the following relation:

$$IR1(t) = \frac{Vdd - VGS(14) - V1(t)}{R1}$$

while the current IR2 (t) that flows across the resistor R2 is given by:

$$IR2(t) = \frac{V2(t) - VGS(16)}{R2}$$

The current fronts are then mirrored at the output of the driver in order to obtain the currents Ip and In, whose equations are given by:

$$Ip = IR2 \times n2 \times n3$$

$$In = IR1 \times n1 \times n4$$

where:

n1 = area of the transistor 15/area of the transistor 14
n2 = area of the transistor 17/area of the transistor 16
n3 = area of the transistor 21/area of the transistor 20
n4 = area of the transistor 19/area of the transistor 18

The switches T1 and T2 are driven by the input signal Tin so as to activate the second current mirror (transistors 16 and 17) and the fourth current mirror (transistors 20 and 21) during the rising front of the output signal Tout and the first current mirror (14, 15) and the third current mirror (18, 19) during the falling front of the output signal.

This produces perfect control of the slew rate without loads or in conditions involving small load capacitances when it is necessary to perform, for example in the case of the RS232 interface, data transmission over coaxial cables.

Moreover, this control occurs only in the initial portions of the switching fronts due to the variation of the voltage VE between the two levels V1 and V2.

Since the two MOS final stages P4 and N4 have the intrinsic technology-dependent characteristic of having different capacitances between the gate and source terminals, it is necessary to be able to independently control the slope of the corresponding switching current front in order to obtain the same rise and fall times for the output voltage.

This is achieved by keeping unchanged the value of the capacitive element C (capacitor 12) and by varying only the currents I1 and I2.

For very large capacitances, the slew rate is instead linked to the capacitive value of the load and to the short-circuit currents (which can be controlled by selecting the dimensions of the current mirrors and of IR1 and IR2), since the variation in the voltage VE from the level V1 to the level V2 occurs in a much shorter time than required by the output signal Tout to move from the value VSS to VDD.

In practice it has been observed that the circuit according to the invention fully achieves the intended aim and objects, since it allows to control very precisely the slew rate of the output signal Tout by means of parameters which can be modified easily and are highly precise.

Moreover, the circuit allows to act independently on the individual switching front, varying the currents supplied by the current sources I1 and I2 independently of each other.

Another advantage of the circuit according to the invention is the fact that it is possible to control the short-circuit current very easily, thus eliminating the drawbacks arising from the use of additional circuits for controlling it.

Additionally, the use of a single capacitor allows to reduce the area occupied by the capacitive element on the chip with respect to known solutions, allowing better integration of the circuit.

The above-described circuit is adapted not only in RS232 interfaces but also whenever it is necessary to drive in a controlled manner a pair of MOS final stages connected in push-pull configuration.

The circuit thus conceived is susceptible of numerous modifications and variations, all of which are within the scope of the inventive concept; all the details may also be replaced with other technically equivalent elements.

In practice, the materials employed, so long as they are compatible with the specific use, as well as the dimensions, may be any according to requirements and to the state of the art.

**Claims**

1. A circuit for controlling the slew rate of the output voltage of a driver in push-pull configuration, comprising: means for generating a pair of currents, said means being driven by switching means which are in turn driven by an input signal of a driver; at least one capacitive element, which is adapted to charge and discharge according to the driving of said current generator means and is suitable to generate positive and negative voltage fronts with a controlled slope; means for converting said voltage fronts into controlled current fronts being provided in order to drive MOS final stages of said driver, the output signal of said driver having a slew rate which can be controlled precisely, said at least one capacitive element receiving at one terminal thereof said currents and being connected, at the other end thereof, to a reference potential such that a triangular waveform is being developed across the terminals of said at least one capacitive element, said means for generating said pair of currents being adjustable independently of each other.

2. The control circuit according to claim 1, **characterized in that** said means for generating a pair of currents comprise a first constant-current source and a second constant-current source which are connected to a noninverting node of an operational amplifier, said capacitive element being connected to said common node.

3. The control circuit according to claim 2, **characterized in that** said operational amplifier is connected to a bipolar transistor in which the emitter terminal is connected to the inverting terminal of said amplifier and the collector terminal is connected to the supply voltage.

4. The control circuit according to claim 3, **characterized in that** said means for converting the voltage fronts into current fronts are connected to the emitter terminal of said bipolar transistor.

5. The control circuit according to claim 1, **characterized in that** said converter means comprise a first current mirror and a second current mirror which are connected to a fourth current mirror and to a third current mirror, respectively, said first and second current mirrors being driven by additional switching means which are driven by said driver input signal.

6. The control circuit according to claim 5, **characterized in that** said additional switching means comprise respective switches for said first mirror and for said second mirror, respective resistors being provided in series to said additional switching means.

7. The control circuit according to claim 5, **characterized in that** said first, second, third and fourth current mirrors comprise, respectively, a pair of P-channel MOS transistors, a pair of N-channel MOS transistors, a pair of P-channel MOS transistors and a pair of N-channel MOS transistors.

8. The control circuit according to claim 7, **characterized in that** said MOS final stages of said driver constitute first transistors of said third and fourth current mirrors respectively.

9. The control circuit according to claim 5, **characterized in that** said first current mirror is connected to the supply voltage and said second current mirror is connected to the ground, said third current mirror and said fourth current mirror being connected, respectively, to a voltage generated by a charge pump circuit and to the corresponding inverted voltage.

10. The control circuit according to claim 2, **characterized in that** said current sources are connected to a reference voltage.

## Patentansprüche

1. Schaltkreis zum Steuern der Anstiegsrate der Ausgangsspannung eines Treibers in Gegentaktkonfiguration, mit:

Mitteln zum Erzeugen eines Strompaars, wobei die Mittel durch Schaltmittel angesteuert sind, die ihrerseits durch ein Eingangssignal eines Treibers angesteuert sind; zumindest einem kapazitiven Element, das ausgestaltet ist zum Laden und Entladen entsprechend der Ansteuerung der Stromerzeugungsmittel und geeignet ist zum Erzeugen positiver und negativer Spannungsflanken mit einem gesteuerten Anstieg; Mitteln zum Umwandeln der Spannungsflanken in gesteuerte Stromflanken, die bereitgestellt sind zum Ansteuern von MOS-Endstufen des Treibers, wobei das Ausgangssignal des Treibers eine Anstiegsrate aufweist, die genau gesteuert werden kann, wobei das zumindest eine kapazitive Element die Ströme an einem seiner Anschlüsse empfängt und an seinem anderen Ende an ein Bezugspotential angeschlossen ist, so dass eine dreieckförmige Wellenform über den Anschlüssen des zumindest einen kapazitiven Elements entsteht, wobei die Mittel zum Erzeugen des Strompaars voneinander unabhängig einstellbar sind.

2. Steuerschaltkreis nach Anspruch 1, **dadurch gekennzeichnet, dass** die Mittel zum Erzeugen eines Strompaars eine erste Konstantstromquelle und eine zweite Konstantstromquelle aufweisen, die mit einem nichtinvertierendem Knoten eines Operationsverstärkers verbunden sind, wobei das kapazitive Element mit dem gemeinsamen Knoten verbunden ist.

3. Steuerschaltkreis nach Anspruch 2, **dadurch gekennzeichnet, dass** der Operationsverstärker mit einem bipolaren Transistor verbunden ist, in dem der Emitteranschluss mit dem invertierenden Anschluss des Verstärkers verbunden ist und der Kollektoranschluss mit der Versorgungsspannung verbunden ist.

4. Steuerschaltkreis nach Anspruch 3, **dadurch gekennzeichnet, dass** die Mittel zum Umwandeln der Spannungsflanken in Stromflanken mit dem Emitteranschluss des bipolaren Transistors verbunden sind.

5. Steuerschaltkreis nach Anspruch 1, **dadurch gekennzeichnet, dass** die Umwandlungsmittel einen ersten Stromspiegel und einen zweiten Stromspiegel aufweisen, die mit einem vierten Stromspiegel bzw. einen dritten Stromspiegel verbunden sind, wobei die ersten und zweiten Stromspiegel durch zusätzliche Schaltmittel angesteuert sind, die durch das Treibereingangssignal angesteuert sind.

6. Steuerschaltkreis nach Anspruch 5, **dadurch gekennzeichnet, dass** die zusätzlichen Schaltmittel entsprechende Schalter für den ersten Spiegel und für den zweiten Spiegel aufweisen, wobei jeweilige Widerstände in Serie zu den zusätzlichen Schaltmitteln vorgesehen sind.

7. Steuerschaltkreis nach Anspruch 5, **dadurch gekennzeichnet, dass** der erste, zweite, dritte und vierteStromspiegeleinPaarvonP-Kanal-MOS-Transistoren, ein Paar von N-Kanal-MOS-Transistoren, ein Paar von P-Kanal-MOS-Transistoren bzw. ein Paar von N-Kanal-MOS-Transistoren aufweisen.

8. Steuerschaltkreis nach Anspruch 7, **dadurch gekennzeichnet, dass** die MOS-Endstufen des Treibers erste Transistoren des dritten bzw. vierten Stromspiegels bilden.

9. Steuerschaltkreis nach Anspruch 5, **dadurch gekennzeichnet, dass** der erste Stromspiegel mit der Versorgungsspannung verbunden ist und der zweite Stromspiegel mit Masse verbunden ist, wobei der dritte Stromspiegel und der vierte Stromspiegel mit einer durch einen Ladungspumpenschaltkreis erzeugten Spannung bzw. mit der entsprechenden invertierten Spannung verbunden sind.

10. Steuerschaltkreis nach Anspruch 2, **dadurch gekennzeichnet, dass** die Stromquellen an eine Bezugsspannung angeschlossen sind.

**Revendications**

1. Circuit de commande de la vitesse de variation de la tension de sortie d'un amplificateur en figuration push-pull comprenant : des moyens générateurs d'une paire de courants, lesdits moyens étant commandés par des moyens de commutation qui sont eux-mêmes commandés par un signal d'entrée d'un amplificateur ; au moins un élément capacitif adapté à se charger et se décharger sous la commande des moyens générateurs de courant et apte à produire des fronts de tension positifs et négatifs de pente commandée ; des moyens convertisseurs des fronts de tension en fronts de courant commandés étant prévus pour piloter des étages MOS finaux de l'amplificateur, le signal de sortie de l'amplificateur ayant une pente qui peut être commandée avec précision, ledit au moins un élément capacitif recevant sur une première borne lesdits courants et étant connecté par son autre borne à un potentiel de référence de sorte qu'une forme d'onde triangulaire est fournie aux bornes dudit au moins un élément capacitif, lesdits moyens générateurs de la paire de courant étant réglables indépendamment l'un de l'autre.

2. Circuit de commande selon la revendication 1, **caractérisé en ce que** les moyens générateurs d'une paire de courants comprennent une première source de courant constant et une seconde source de courant constant qui sont connectées à un noeud non inverseur d'un amplificateur opérationnel, l'élément capacitif étant connecté au noeud commun.

3. Circuit de commande selon la revendication 2, **caractérisé en ce que** l'amplificateur opérationnel est connecté à un transistor bipolaire dont la borne d'émetteur est connectée à la borne inverseuse de l'amplificateur et la borne de collecteur est connectée à la tension d'alimentation.

4. Circuit de commande selon la revendication 3, **caractérisé en ce que** lesdits moyens convertisseurs des fronts de tension en fronts de courant sont connectés à la borne d'émetteur du transistor bipolaire.

5. Circuit de commande selon la revendication 1, **caractérisé en ce que** les moyens convertisseurs comprennent un premier miroir de courant et un second miroir de courant qui sont connectés à un quatrième miroir de courant et à un troisième miroir de courant, respectivement, les premier et second miroirs de courant étant pilotés par des moyens de commutation supplémentaires qui sont fournis par le signal d'entrée de commande.

6. Circuit de commande selon la revendication 5, **caractérisé en ce que** les moyens de commutation

11       **EP 1 001 535 B1**       12

supplémentaires comprennent des commutateurs respectifs pour le premier miroir et pour le second miroir, des résistances respectives étant prévues en série avec les moyens de commutation supplémentaires.

**7.** Circuit de commande selon la revendication 5, **caractérisé en ce que** les premier, second, troisième et quatrième miroirs de courant comprennent respectivement deux transistors MOS à canal P, deux transistors MOS à canal N, deux transistors MOS à canal P et deux transistors MOS à canal N.

**8.** Circuit de commande selon la revendication 7, caractérisé en que les étages MOS finaux de l'amplificateur constituent des premiers transistors des troisième et quatrième miroirs de courant, respectivement.

**9.** Circuit de commande selon la revendication 5, **caractérisé en ce que** le premier miroir de courant est connecté à la tension d'alimentation et le second miroir de courant est connecté à la masse, le troisième miroir de courant et le quatrième miroir de courant étant connectés, respectivement, à une tension produite par un circuit de pompe de charge et à une tension inversée correspondante.

**10.** Circuit de commande selon la revendication 2, **caractérisé en ce que** les sources de courant sont connectées à une tension de référence.

Fig. 1

Fig. 2

EP 1 001 535 B1